Europäisches Patentamt

European Patent Office

Office européen des brevets

(11) Publication number: **0 171 474**
**B1**

## (12) EUROPEAN PATENT SPECIFICATION

(45) Date of publication of patent specification: **24.05.89**

(21) Application number: **84305595.5**

(22) Date of filing: **17.08.84**

(51) Int. Cl.⁴: **H 01 L 29/743, H 01 L 29/08, H 01 L 29/10, H 01 L 21/225**

Ⓢ④ A method for producing a thyristor device.

(43) Date of publication of application:
**19.02.86 Bulletin 86/08**

(45) Publication of the grant of the patent:
**24.05.89 Bulletin 89/21**

(84) Designated Contracting States:
**DE FR IT**

(56) References cited:
**EP-A-0 029 887**
**EP-A-0 035 841**
**DE-A-2 802 727**
**DE-A-3 029 836**
**DE-A-3 226 327**
**GB-A- 972 853**
**GB-A-1 351 867**
**GB-A-2 135 118**
**US-A-4 236 169**

(73) Proprietor: **WESTINGHOUSE BRAKE AND SIGNAL HOLDINGS LIMITED**
**Pew Hill**
**Chippenham Wiltshire (GB)**

(72) Inventor: **Garrett, John Mansell**
**17 The Parklands Hullavington**
**Chippenham Wiltshire SN14 6DL (GB)**

(74) Representative: **Bird, Vivian John et al**
**PAGE & CO. Temple Gate House**
**Temple Gate Bristol BS1 6PL (GB)**

Courier Press, Leamington Spa, England.

## Description

The present invention relates to a method for producing a thyristor device.

The invention is particularly concerned with thyristor devices produced by diffusion processes. When an impurity is diffused into semiconductor material from one major face of a basic element, the impurity concentration is greatest adjacent the major face and progressively declines with increasing depth, substantially in accordance with an error function curve.

The dynamic switching characteristics of semiconductor thyristor devices are to a great extent influenced by a single common factor in the form of the controlling base layer resistivity or conductivity affecting both turn-on and turn-off capabilities of devices.

When the conductivity regions of a semiconductor device are produced by a diffusion process, resistivity is greatest at depth and decreases gradually towards the surface.

In a shorted-emitter thyristor, ideally the lateral resistance of the base layer should be low and the effective resistance between any point in the base layer and the emitter contact should be relatively higher. This is the opposite of the result of applying a normal diffusion process to the fabrication of a thyristor, so the practical approach is a compromise at which the base layer has the highest value of resistance which will permit either the desired dV/dt or the desired turn-off/turn-on performance to be achieved. As prior art in this field there may be mentioned EP—A—0 035 841 providing an additional resistive film between emitter metallisation and short in order to increase the series resistance of the short.

In a gate turn-off thyristor, the maximum load current which can be turned off is directly related to the gate extraction current which, in turn, is limited by the resistance of the controlling base layer and the maximum usable gate voltage. Thus, the resistivity of the base layer is preferably low while the gate voltage limit is determined by the reverse breakdown voltage of the emitter-base junction which is improved if the base layer resistivity is high. Again this requires a conductivity profile which is opposite to that produced in conventional diffusion processes.

GB—A—1 351 867 describes the fundamental problem of "normally graded" diffused semiconductor layers in the base region of thyristors and proposes the production of a "reverse graded" layer by epitaxial deposition. Epitaxial processes are inherently more expensive than diffusion and have a tendency to produce a laterally nonuniform layer particularly evident on the relatively large surface area elements characteristic of the thyristor devices.

The basis of the present invention, in contrast to GB—A—1 351 867, involves the use of an out-diffusion step to lower the concentration of impurity levels adjacent a major face whereby the lateral or sheet resistance of a desired layer may be controlled to the extent of favourably influencing the characteristics of the finished device. Although an out-diffusion step, per se, is disclosed in GB—A—972 853 which describes limited source diffusion and two-stage diffusion in the production of a germanium transistor, there is no disclosure therein of the use of out-diffusion in a thyristor device.

According to the present invention, there is provided a method for producing a thyristor device comprising a semiconductor body having a plurality of superimposed semiconductor layers of alternating conductivity type, in which method a controlling base region is produced by diffusing into a surface of the semiconductor body p-dopant from a p-dopant source to a predetermined depth, the method being characterised in that after a time the p-dopant source is removed and the diffusion process continued in the absence of the p-dopant source for a time sufficient to drive the p-dopant further into the body to a depth sufficient to define the controlling base region and to out-diffuse p-dopant in the body from the said surface to provide a graduated p-dopant concentration profile having maximum value at a depth substantially at the midpoint of the controlling base region.

For a better understanding of the present invention and to show how it may be carried into practice, reference will now be made, by way of example only, to the accompanying drawings, in which:

Fig. 1 is a schematic illustration of a section through a shorted-emitter thyristor;

Fig. 2(a) shows comparative dopant profiles of shorted-emitter thyristors produced according to an existing method and a method according to the invention;

Fig. 2(b) shows dopant concentration in a finished device made according to the invention, e.g. on section X—X in Figs. 1 and 4;

Fig. 3 shows a schematic cross-section through a gate turn-off thyristor having a mesa cathode structure;

Fig. 4 shows a similar cross-section through a gate turn-off thyristor having planar structure; and

Fig. 5 shows the relative positions of the junctions in respect of the base layer dopant concentration profile for shorted-emitter and gate turn-off thyristors.

In a shorted-emitter thyristor, in order for an emitter short to be effective, the lateral resistance in the p-base layer between any part of the emitter and the body of a short must have a sufficiently low value. On the other hand, for the conduction property not to be induly impaired, the effective resistance between any point in the base and the emitter contact via the shorting path should have a relatively high value. Furthermore, the effective value of the lateral resistance should ideally be the same for all points in the emitter layer.

Theoretically, therefore, an efficient shorted-emitter thyristor structure might be expected to possess zero p-base resistance (disregarding the effect of this on emitter injection efficiency) and a series resistance in the electrical shorting path between the p-base and the emitter electrode. In practice, this type of structure should be closely approached if the distributed p-base resistance is as low as possible and a relatively large resistance is contained within the structure of the emitter short itself.

One example of the present invention modifies the diffusion process, by which the base layer of p-type conductivity is produced, in order to graduate the resistivity of that portion of the region later masked during n-type emitter diffusion so as to produce emitter shorts having the desired characteristics. After the p-doped layers have been formed by a conventional diffusion process, there is a slight tendency, during later processing, e.g. oxide masking and emitter diffusion stages, for the surface layers of the p-base diffusion to "out-diffuse". The p-dopant evaporates from the surface of the silicon slice resulting in a thin surface layer being depleted of p-dopant but having virtually insignificant depth.

The invention enables a very much enhanced out-diffusion penetrating into the silicon slice to a much greater depth to produce a significant inverted concentration profile compared to that originally imposed to cause the normal in-diffusion. By adjustment of the periods of time of the presence and absence of a p-dopant source during this procedure and appropriate adjustment of the other parameters which affect the diffusion process, the out-diffusion effect may be closely controlled so as to produce a sufficiently depleted region to substantially the same depth as the subsequent n-emitter diffusion.

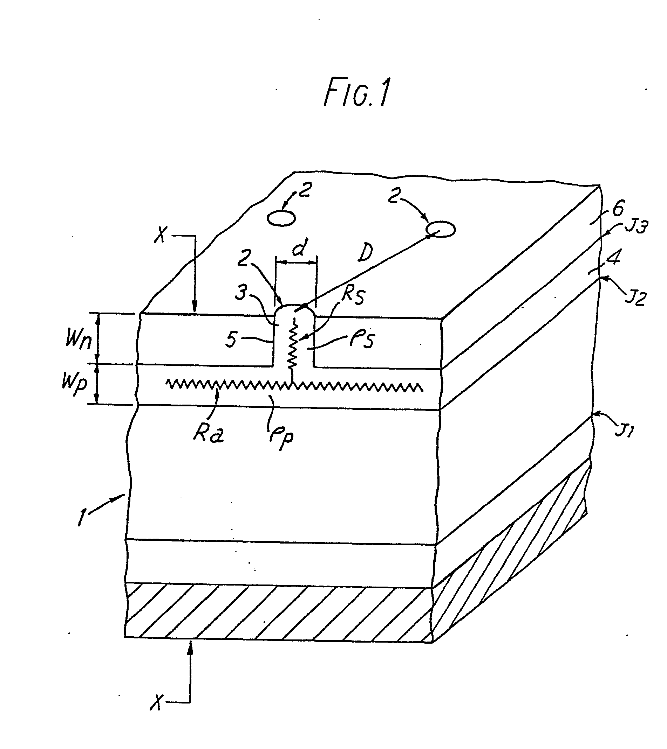

Referring now to the drawings, Fig. 1 shows a section through a thyristor 1 having a shorted emitter construction. The shorts 2 comprise columns 3 of p-type semiconductor material rising from the p-type base layer 4 through perforations 5 in the overlying n-type emitter layer 6. The shorts are circular in section, having diameter $d$, and are arranged in a regular triangular array over the whole surface of the device, with an inter-short spacing D.

It can be shown that in a device of the type illustrated with the form of short configuration shown, the effective distributed lateral base resistance is closely approximated by:—

$$Ra = \frac{\rho_p}{4\pi Wp} [2 \ln(D/d) + (d/D)^2 - 1]$$

where
Ra=distributed lateral base resistance at maximum inter-short distance
D=inter-shot spacing
d=short diameter
$\rho_p$=mean resistivity of p-type base layer and
Wp=depth of p-type base layer
and the short series resistance by:—

$$Rs = \frac{4\rho sWn}{\pi d^2}$$

where
Rs=emitter short series resistance
$\rho s$=mean resistivity of p-type material in a column of the short and
Wn=depth of n-type emitter layer.
The total short resistance R (short) is thus the sum of these two expressions, i.e.

$$R \text{ (short)} = Ra + Rs.$$

The object of the invention as regards a shorted-emitter thyristor can be expressed in terms of increasing the ratio Rs/Ra. The proposed method seeks to increase the value of Rs without significantly affecting the value of Ra relative to a conventional device. Although there is no absolute restriction, in theoretical terms, on the value of Rs there is every indication that a thyristor device in which Rs<<Ra would not produce an effective improvement compared to present thyristor constructions. On the other hand, it is expected that improvements in performance will result generally when Rs is at least equal to Ra/10 and preferably Rs>>Ra/10.

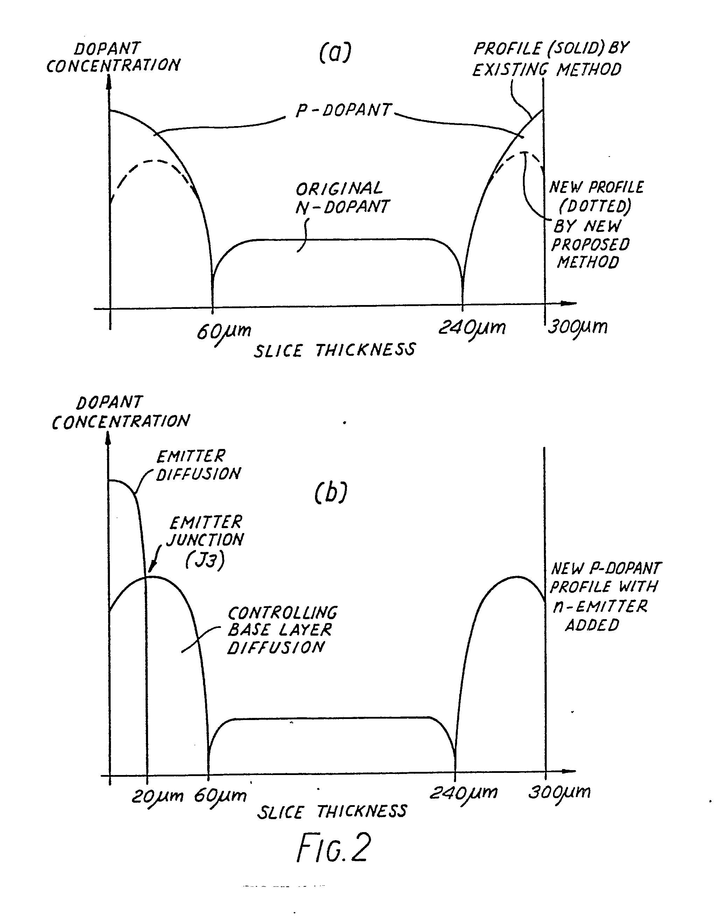

In a thyristor constructed according to the proposed method, the base layer lateral resistance Ra has a characteristic virtually indistinguishable from that which would be produced by conventional known methods in a similar device. For comparison, Fig. 2(a) shows a dopant profile (solid line) produced by conventional or existing methods and that (dotted line) produced by the proposed method.

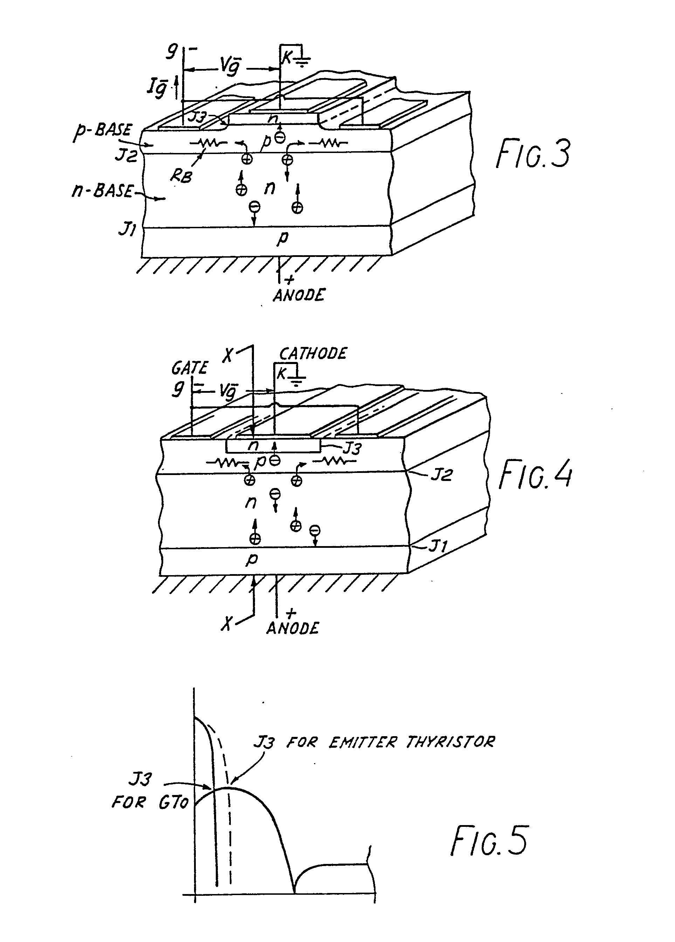

In Fig. 2(a), the p-dopant concentration profile produced by an existing conventional diffusion process is represented by the solid line and the modified p-dopant profile resulting from the out-diffusion of the presently proposed diffusion process is shown by the dotted line. The out-diffusion effect is produced by removing the p-dopant source at a stage sufficiently early in the process to cause an enhanced surface depletion of p-type dopant in the p-type regions then being formed by permitting out-diffusion to continue for a period of time. An increase in the initial p-dopant surface concentration may be used in order to compensate for its early removal so as to produce a p-base region under the subsequent emitter diffusion region (see Fig. 2(b)) which has very similar properties, particularly in respect of injection efficiency and transport factor, relative to a conventionally produced profile. Gallium has been found to be a particularly suitable dopant as the diffusion of gallium atoms into and out of a silicon surface is not significantly impeded by the presence of surface oxides. A typical final profile of dopant concentrations including the emitter diffusion, as may be found on the section X—X in the devices of Figs. 1 and 4, is shown in Fig. 2(b). It is to be particularly noted that the controlling base layer has a dopant concentration peak intermediate its upper and lower depth limits, e.g. at approximately 30 μm below the emitter surface of the device. The emitter diffusion, however, extends to a lesser depth of approximately 15 μm, forming the emitter junction in the region of its lower limit.

The effective resistivity ρs of the surface region which is utilised to form the emitter shorts, which have the resistance Rs, may thus be increased by a factor of up to 10 times. For a given value of Rs, short resistance, the cross-sectional area of the short ($\pi/4\ d^2$) can be increased by a corresponding factor, yielding an increase in short diameter d of $\sqrt{10}$ times, i.e. 3.16. This obviates problems which may arise because the short diameter is too small for easy working since the present invention permits the short diameter to be increased to a more convenient size whilst enabling a desired short resistance to be achieved. For example, in a typical device having a total emitter short surface area of 2% of total emitter area, the invention could permit this area to be increased to a maximum of approximately 20%. However, such a high figure is exceptional and in general terms the range of emitter short area is expected to be 5% to 12% of total cathode emitter area.

By way of further example, in a typical device of the type referred to earlier in the above given equations, having a high density of small shorts, conventional design calculations provide an inter-short spacing D=300 μm, and a short diameter d=50 μm which give a total shorted area of 2.5% of total emitter area.

Taking the following values:

depth of n-type layer Wn=20 μm
depth of p-type layer Wp=40 μm

then

$$Ra = \frac{\rho p}{4\pi Wp}\ [\ 2\ \ln(D/d) + (d/D)^2 - 1]$$

$$= 52\ \rho p$$

and

$$Rs = \frac{4\rho sWn}{\pi d^2}$$

$$= 102\ \rho s$$

so that the ratio Rs/Ra≃2 ρs/ρp

In a conventional device, a typical value of the resistivity ratio ρs/ρp is approximately 0.1 so that Rs/Ra=0.2

In the corresponding device constructed using the present invention the diffusion profile may be modified to provide a resistivity ratio of:

$$\rho s/\rho p = 0.5$$

so that Rs/Ra=1.

The diffusion profiles outlined above will be found generally satisfactory where aluminium surface contacts are applied by evaporation followed by sintering or, particularly as applied to the anode face, by alloying with aluminium or an aluminium alloy. Where other forms of contact are desired, e.g. nickel plating, the surface concentration of normal p-dopant (typically gallium) may be boosted initially with e.g. boron in order to obtain reliable low resistance contact properties. Boron is particularly suitable as it has a low diffusion constant but a high solubility in silicon. This is not inconsistent with the present invention provided the depth of penetration of boost dopant is small compared to the depth of the outdiffused effect.

In a gate turn-off thyristor, the current which can be turned off is directly related to the gate extraction current which in turn is jointly determined by two factors: firstly, the conductance of the p-base region through which majority carriers have to be extracted to the extracting terminal, i.e. the gate terminal; and secondly, the maximum voltage Vg which can be used to effect such extraction.

As shown in Figs. 3 and 4, the maximum voltage Vg is effectively the reverse breakdown voltage of the emitter base junction J3, which can be improved if the resistivity of the p-base layer is relatively high. In contrast, for a given emitter dimension, the conductance of the p-base layer is improved by keeping its resistivity to a mimimum.

As previously mentioned, the normal gradation of p-base resistivity as formed by conventional diffusion processes is at a maximum at the junction J2 falling to a minimum at the device surface, with the junction J3 lying generally at an intermediate resistivity. In a device as shown in Fig. 4 this junction J3 rises to the surface at the edges of the emitter where its breakdown voltage will therefore be at a mimumum.

The breakdown voltage of junction J3 in a device made according to the invention is increased compared to that of a prior art device having the same average p-base resistivity under junction J3 and the product of a breakdown voltage and the underlying p-base conductivity is consequently increased. Also, this obviates the penalty of the junction J3 appearing at the device surface, as in Fig. 2, since the resistivity towards the surface is now increasing as a result of which the breakdown voltage is not lowered.

Preferably, the depth of the emitter diffusion to form junction J3 does not exceed the depth of the maximum diffused concentration of the p-base region. Whereas the lateral base resistance is determined by the harmonic mean value of base resistivity, the p-base resistivity operative in respect of voltage breakdown of junction J3 is determined by the minimum resistivity anywhere approaching the junction. Therefore, there may be further advantage in forming the emitter base junction J3 at a shallower depth from the surface in a gate turn-off thyristor compared to a shorted-emitter thyristor as shown in the relative profiles of Fig. 5.

## Claims

1. A method for producing a thyristor device comprising a semiconductor body having a plurality of superimposed semiconductor layers of alternating conductivity type, in which method a controlling base region is produced by diffusing into a surface of the semiconductor body p-dopant from a p-dopant source to a predetermined depth, the method being characterised in that after a time the p-dopant source is removed and the diffusion process continued in the absence of the p-dopant source for a time sufficient to drive the p-dopant further into the body to a depth sufficient to define the controlling base region and to out-diffuse p-dopant in the body from the said surface to provide a graduated p-dopant concentration profile having maximum value at a depth substantially at the midpoint of the controlling base region.

2. A method as claimed in claim 1, characterised in that the semiconductor body comprises silicon and the p-dopant comprises gallium.

3. A method as claimed in claim 1 or claim 2, characterised in that it further includes the step of diffusing an n-dopant into the surface of the semiconductor body to substantially the maximum value point of p-dopant concentration in the base region to form an n-emitter region.

4. A method as claimed in any preceding claim, characterised in that the initial p-dopant surface concentration is boosted in order to compensate for relatively early removal of the p-dopant source.

5. A method as claimed in claim 4, characterised in that the p-dopant is boosted by an additional dopant.

6. A method as claimed in Claim 5, characterised in that the additional boost dopant is boron.

## Patentansprüche

1. Verfahren zur Herstellung einer Thyristoranordnung, welche einen Halbleiterkörper mit einer Mehrzahl an übereinander angeordneten Halbleiterlagen abwechselnden Leitfähigkeitstyps aufweist, bei welchem Verfahren ein Steuerungs-Basisbereich durch Diffusion eines p-Dotierungsmittel aus einer p-Dotierungsmittelquelle in eine Oberfläche des Halbleiterkörpers bis zu einer vorbestimmten Tiefe erzeugt wird, und das Verfahren dadurch gekennzeichnet ist, daß nach einer Zeitspanne die p-Dotierungsmittelquelle entfernt wird und der Diffusionsvorgang in der Abwesenheit der p-Dotierungsmittelquelle über eine ausreichende Zeitspanne fortgeführt wird, um das p-Dotierungsmittel weiter in den Körper mit einer ausreichenden Tiefe hineinzutreiben, um den Steuerungs-Basisbereich abzugrenzen und das p-Dotierungsmittel in dem Körper von der Oberfläche her auszudiffundieren, um ein abgestuftes p-Dotierungsmittel-Konzentrationsprofil zu erzeugen, welches den maximalen Wert in einer Tiefe hat, die etwa am Mittelpunkt des Steuerungs-Basisbereichs liegt.

2. Verfahren nach Anspruch 1, dadurch gekennzeichnet, daß der Halbleiterkörper Silizium enthält und das p-Dotierungsmittel Gallium umfaßt.

3. Verfahren nach einem der Ansprüche 1 oder 2, dadurch gekennzeichnet, daß es weiterhin die Stufe der Diffusion eines n-Dotierungsmittel in die Oberfläche des Halbleiterkörpers hinein im wesentlichen zum Maximalwertpunkt der p-Dotierungsmittelkonzentration in dem Basisbereich miteinschließt, um einen n-Emitterbereich zu bilden.

4. Verfahren nach einem der vorangehenden Ansprüche, dadurch gekennzeichnet, daß die anfängliche p-Dotierungsoberflächenkonzentration erhöht wird, um eine relativ frühzeitige Entfernung der p-Dotierungsmittelquelle zu kompensieren.

5. Verfahren nach Anspruch 4, dadurch gekennzeichnet, daß das p-Dotierungsmittel durch ein zusätzliches Dotierungsmittel verstärkt wird.

6. Verfahren nach Anspruch 5, dadurch gekennzeichnet, daß das zusätzliche Verstärkungsdotiermittel Bor ist.

## Revendications

1. Procédé de fabrication d'un dispositif à thyristor comprenant un corps de semiconducteur ayant une pluralité de couches de semiconducteur superposées de type de conductivité alterné, dans lequel procédé une région de base de commande est produite en diffusant dans une surface du corps de semiconducteur un dopant p à partir d'une source de dopant p jusqu'à une profondeur prédéterminée, le procédé étant caractérisé en ce qu'après un certain temps la source de dopant p est retirée et le processus de diffusion est continué en l'absence de la source de dopant p pendant une durée suffisante pour faire pénétrer encore le dopant p dans le corps jusqu'à une profondeur suffisante pour définir la région de base de commande et pour diffuser vers l'extérieur le dopant p dans le corps à partir de ladite surface pour obtenir un profil de concentration gradué en le dopant p ayant une valeur maximale à une profondeur située sensiblement au centre de la région de base de commande.

2. Procédé selon la revendication 1, caractérisé en ce que le corps de semiconducteur comprend du silicium et le dopant p comprend du gallium.

3. Procédé selon la revendication 1 ou la revendication 2, caractérisé en ce qu'il comprend en outre l'étape de diffuser un dopant n dans la surface du corps de semiconducteur sensiblement jusqu'au point de valeur maximale concentration en dopant p dans la région de base pour former une région d'émetteur n.

4. Procédé selon l'une quelconque des revendications précédentes, caractérisé en ce que la concentration superficielle initiale en dopant p est renforcée afin de compenser le retrait relativement précoce de la source de dopant p.

5. Procédé selon la revendication 4, caractérisé en ce que le dopant p est renforcé par un dopant supplémentaire.

6. Procédé selon la revendication 5, caractérisé en ce que le dopant de renforcement supplémentaire est le bore.

## FIG.1

FIG. 2

FIG.3

FIG.4

J3 FOR EMITTER THYRISTOR

J3 FOR GTo

FIG.5